# EUROPEAN PATENT APPLICATION

(11) **EP 4 815 033 A1**
(43) Date of publication of application: **30.09.2026**
(21) Application number: 25166784.6
(22) Date of filing: 27.03.2025
(51) Int. Cl.: H01L 21/67, H01L 21/68

(54) **METHOD AND COMPUTER PROGRAM PRODUCT FOR BONDING SUBSTRATES**

(71) Applicant: ASML Netherlands B.V., 5500 AH Veldhoven (NL)
(72) Inventor: MIDDLEBROOKS, Scott, Anderson, 5500 AH Veldhoven (NL); VAN KRAAIJ, Markus, Gerardus, Martinus, Maria, 5500 AH Veldhoven (NL); WANG, Sheng, 5500 AH Veldhoven (NL); VENUGOPALAN, Syam, Parayil, 5500 AH Veldhoven (NL)
(74) Representative: ASML Netherlands B.V.

(57) **Abstract**

Disclosed is a method of bonding substrates to form a bonded substrate, comprising: assigning M labels to N first substrates based on similarity between the N first substrates such that each of the N first substrates is assigned with one of the M labels, where M and N are both integers and where M<N; and selecting one first substrate from among the N first substrates for bonding with a second substrate based on the labels of the N first substrates and one or more characteristics of the second substrate.

## Description

### FIELD OF INVENTION

The present invention relates to a method and apparatus for lithography and in particular to a method and apparatus for bonding substrates to form a bonded substrate.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"direction) while synchronously scanning the substrate parallel or anti-parallel to this direction. It is also possible to transfer the pattern from the patterning device to the substrate by imprinting the pattern onto the substrate.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer.

In die-to-wafer bonding, individual dies or chiplets are bonded to an acceptor wafer or substrate (i.e., a base patterned substrate). A wafer reconstitution (or wafer reconstruction) may then be performed, comprising one or more processing steps to, for example, fill in gaps between the individual dies. The reconstituted wafer undergoes one or more further lithography processes (patterning steps), e.g., to form connections between patterns on the individual dies and patterns on the reconstituted wafer (and/or other individual dies).

It is desirable to improve lithography processes on reconstituted wafers in the manufacture of integrated devices.

### SUMMARY OF THE INVENTION

In a first aspect of the invention, there is provided a method of bonding substrates to form a bonded substrate, comprising: assigning M labels to N first substrates based on similarity between the N first substrates such that each of the N first substrates is assigned with one of the M labels, where M and N are both integers and where M<N; and selecting one first substrate from among the N first substrates for bonding with a second substrate based on the labels of the N first substrates and one or more characteristics of the second substrate.

In a second aspect of the invention, there is provided a computer program operable to perform the method of the first aspect.

In a third aspect of the invention, there is provided a substrate obtained by performing the method of the first aspect.

In a fourth aspect of the invention, there is provided a substrate bonding apparatus being operable to perform the method of the first aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
- Figure 1 depicts schematically a lithographic apparatus together with other apparatuses forming a production facility for semiconductor devices;
- Figure 2 depicts schematically a die-to-wafer bonding process; and
- Figure 3 depicts schematically four components of an example intra-die overlay fingerprint;
- Figure 4 shows a flowchart of the proposed method of bonding substrates to form a bonded substrate in accordance with an embodiment;
- Figure 5 shows an example plot of the N processed field matrices (each comprising first two principal components) obtained after having applied principal component analysis to the N field matrices; and
- Figure 6 shows an example implementation of using K-means clustering to group the N processed feature matrices (e.g., as shown in Figure 5) into M (e.g., 7) feature clusters, wherein the centroid or cluster center of each feature cluster is indicated by a white cross.

### DETAILED DESCRIPTION

Before describing embodiments of the invention in detail, it is instructive to present an example environment in which embodiments of the present invention may be implemented.

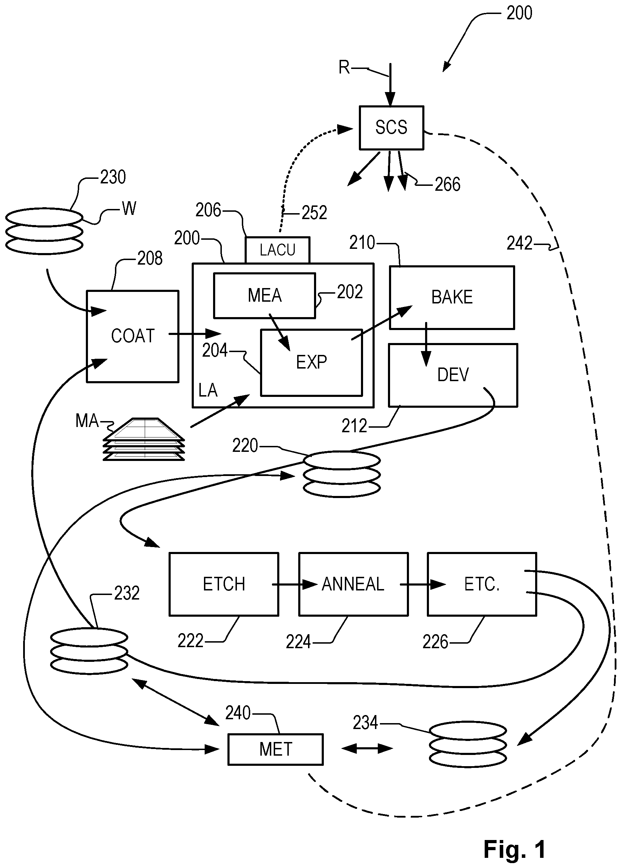

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. Note that the term wafer and substrate (at least within the context of a semiconductor substrate onto which a pattern is transferred in a lithography step) are used synonymously herein. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and substrate optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

Die-to-Wafer comprises using a bonding tool to bond a number of individual substrate portions or dies to an acceptor or base substrate (or wafer), e.g., to provide a heterogeneous 3D integration of the individual dies onto the substrate. The dies, for example, may have multiple different data processing and/or storage functionalities and different dimensions.

Recent technology trends include the processing of so-called reconstituted wafers. Reconstituted wafers typically comprise a patterned base or acceptor substrate with multiple dies bonded thereon, after which the gaps in between the dies are filled with a material (e.g., oxide or oxynitride material). A subsequent process of flattening and cleaning prepares the reconstituted wafers for further wafer-level patterning. The further wafer-level patterning may comprise, for example, patterning of through-silicon-vias (TSVs), re-distribution layers (RDLs) and/or other functional structures. This patterning is executed using lithography equipment, e.g., a scanner or lithographic apparatus used for patterning conventional wafers. This may comprise the patterning of one or more layers, with additional processing steps (deposition, etch etc.) such as illustrated in Figure 1.

As such, the manufacture of a reconstituted wafer may comprise the use of *inter alia* one or more lithographic apparatuses to pattern the acceptor wafer (base patterned wafer) and one or more other wafers (pre-diced wafers) from which the individual to-be-bonded dies are cut, and a bonding tool to bond the dies to the acceptor wafer.

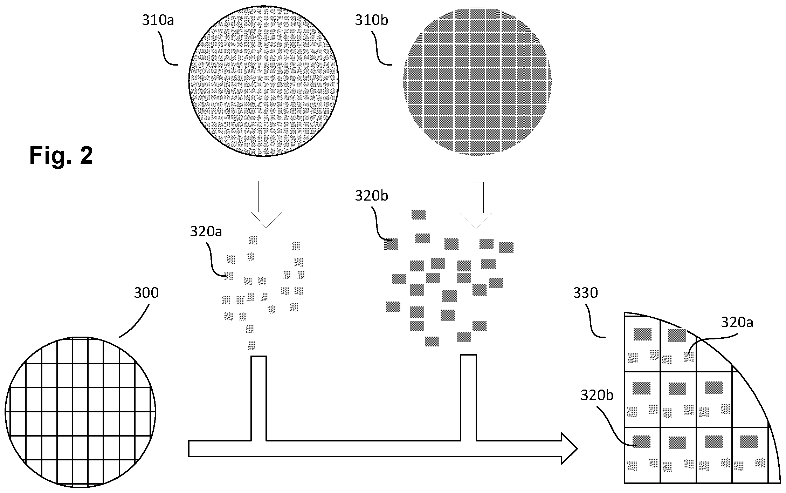

Figure 2 illustrates the basic concept of manufacturing a reconstructed wafer. The acceptor wafer or base patterned wafer (base substrate) 300 has been patterned in one or more lithographic steps, and further processed (e.g., etched etc.) in one or more processing steps, as part of an integrated circuit (IC) manufacturing process (e.g., such as illustrated in Figure 1). This patterning and processing may have formed multiple layers onto the wafer as is well known in IC manufacture. Similarly, one or more pre-diced wafers (pre-diced substrates) 310a, 310b are manufactured in a similar manner (although with different patterns/product) as the base patterned wafer 300. In this specific example, two pre-diced wafer types 310a, 310b are produced, each comprising multiple repetitions of a respective different circuit. Pre-diced wafers 310a, 310b are then diced to produce individual substrate portions or dies 320a, 320b. These individual dies 320a, 320b are then bonded to the base patterned wafer 300 to produce a die-to-wafer bonded wafer 330 (only a portion of which is shown). The number of individual dies 320a, 320b (and/or number of different types of dies) bonded to the base patterned wafer 300 may vary from shown here. For example, each field and/or die of the base patterned wafer 300 may have bonded thereto one or more dies respectively of one or more different die types. The bonded wafer 330 may undergo additional processing steps (e.g., *inter alia* to fill gaps between the bonded dies) to form a reconstituted wafer. Subsequently additional lithography steps are performed on the reconstituted wafer as has been described.

The additional lithography steps performed on the reconstituted wafer for one or more layers which need to align to the top layer of the reconstituted wafer. Therefore, the position of features on this top layer needs to be known with sufficient accuracy to form functional bonded dies. However, this is more difficult than for a conventional wafer. The reasons for this are fourfold:
1) The pre-diced wafers, and therefore the dies cut therefrom, have respective different edge placement and overlay errors. These dies will maintain these errors when bonded to the base patterned wafer.
2) The dies may originate from different pre-diced wafers and from different locations within those pre-diced wafers. For example, for the same bonding location on two or more reconstituted wafers, there may be wafer-to-wafer variation in the respective location within the pre-diced wafer from which the die being bonded was cut. This may be the case, for example, when a die on a pre-diced wafer does not yield and another die is used in its place or when not all the dies of a pre-diced wafer are bonded to the same base patterned wafer.
3) The bonding tool which is used for the die-to-wafer bonding does not place dies on the base patterned wafer with perfect accuracy. Each die bonded on a base patterned wafer will have a different respective bonding placement error.
4) The process of die-to-wafer bonding warps both the dies and the complete reconstituted wafer, inducing displacements of features on the top layer (additional to those described at reason 1) above).

A consequence of these factors is that displacements of the top layer of the reconstituted wafer are likely to be discontinuous across-wafer (i.e., between fields and dies) and are also likely to vary wafer-to-wafer for the reconstituted wafers.

Because of this, accurate positioning and overlay control of the subsequent patterning on the reconstituted wafer presently requires every individual die to be measured individually with dense alignment metrology to properly characterize the discontinuous positional errors. This is slow, meaning that throughput is relatively low making the technology less cost-effective.

Currently, there is a growing interest in using die-to-wafer or wafer-to-wafer hybrid bonding to improve the energy efficiency performance of microprocessor chips. Die-to-wafer or wafer-to-wafer hybrid bonding with a high lateral placement accuracy in the vertical stack is crucial to guarantee small electrical contacts. This is achieved using die-to-wafer or wafer-to-wafer bonding tools. The performance of a die-to-wafer bonding tool or apparatus may be characterized by its placement accuracy (e.g., how accurately a die can be placed on a target position of an acceptor wafer) and its throughput (e.g., in terms of the number of die-placements per hour). At present, existing die-bonding tools are not capable of providing a placement accuracy of lower than 100 nm and a throughput of more than 10000 die-placements per hour. Intra-die overlay fingerprint is one of the main bottlenecks that impede existing bonding solutions from reaching such placement accuracies and throughputs.

Thus, to further improve the post-bonding performance of a bonded wafer (e.g., a die-to-wafer bonded wafer), it is desirable to maximally correct the intra-die overlay fingerprint of a bonded die. With reference to Figure 1, an intra-die overlay fingerprint ROL may be decomposed into four fingerprint components, i.e. a translation error TE, a rotation error RE, a magnification error ME, and a residue error RES. Among these fingerprint components, the translation error TE, the rotation error RE and the magnification error ME may be substantially correctable while the residue error RES may not be correctable and may remain in the bonded wafer (e.g., the die-to-wafer bonded wafer 330). Specifically, the translation error TE and the rotation error RE may be corrected by a die-bonding tool. A symmetrical component of the magnification error ME may be substantially corrected by a die-bonding tool while an asymmetrical component of the magnification error ME may be substantially pre-corrected by a scanner prior to the bonding process.

For a die with a width of 10mm and a thickness of 50 µm, the intra-die overlay fingerprint is typically around 300 nm which may be broken down into a ~200 nm translation error, a ~ 20 nm rotation error, a ~150 nm magnification error, and a ~20 nm residual error. With a die-bonding tool, it is possible to substantially correct the translation error (e.g., reducing the error from 200 nm to 20 nm) and the rotation error (e.g., reducing the error from 3 mRad to 3 nRad) through actuation of the die holder (for holding a donor die) and/or the wafer stage (for holding an acceptor wafer). The magnification error may be substantially corrected by the die-bonding tool together with the scanner. However, in the most optimistic scenario where these correctable fingerprint components are fully corrected, there is still a ~20 nm residual overlay error (or residual overlay fingerprint) in the die. The intra-die residual overlay error and other non-correctable overlay errors (e.g., resulting from the bonding process) fundamentally limit the overlay of the bonded wafer to be above 50 nm.

The impact of such a residual overlay error of the donor die on the bonded wafer may be reduced or minimized if the residual overlay error of the donor die matches with an overlay fingerprint of at least a bonding portion of the acceptor wafer. In such a manner, the residual overlay error of the donor die and the overlay fingerprint of the acceptor wafer substantially cancel each other out. Brute-force search can be used to search for optimal pairwise matches between N donor dies (N is an integer) and an acceptor wafer. However, such a technique would require N factorial calculations, which is computationally impractical. Therefore, it is desirable to have a die-to-wafer or wafer-to-wafer matchmaking method that is more efficient and less computationally intensive than existing methods.

Accordingly, an aspect of the present disclosure provides a method of bonding substrates to form a bonded substrate. The proposed method may comprise assigning M labels to N first substrates based on similarity between the N first substrates such that each of the N first substrates is assigned with one of the M labels, where M and N are both integers and where M<N. The proposed method may further comprise selecting one first substrate from among the N first substrates for bonding with a second substrate based on the labels of the N first substrates and one or more characteristics of the second substrate.

The proposed method may not only be suitable for selecting a die from among a plurality of individual dies for bonding with a wafer (or a reconstituted wafer) but may also be suitable for selecting a wafer from among a plurality of wafers or selecting or a reconstituted wafer from among a plurality of reconstituted wafers for bonding with another wafer or another reconstituted wafer. Accordingly, the N first substrates may be N individual dies, or N dies of a reconstituted wafer, or N individual wafers, or N individual reconstituted wafers, and the second substrate may be a wafer or a reconstituted wafer.

In an embodiment, the step of assigning M labels to N first substrates may comprise determining a clustering structure of the N first substrates based on N sets of first measurement data. Each of the N sets of first measurement data may be associated with a respective one of the N first substrates. The M labels may be associated with M substrate clusters respectively. The clustering structure may be determined based on similarity between fingerprints of the respective N sets of first measurement data. In an embodiment, the step of assigning M labels to N first substrates may further comprise labelling each of the N first substrates with one of the M labels based on the clustering structure.

In an embodiment, the clustering structure may be determined by first obtaining the N sets of first measurement data after having performed measurements on the N first substrates. The N sets of first measurement data may then be used to determine N feature matrices, wherein each of the N feature matrices may be composed of at least one feature vector and values thereof and each of the N feature matrices may be associated with a respective one of the N sets of first measurement data. Then, the N first substrates may be grouped into the M substrate clusters based on at least the determined N feature matrices so as to obtain the clustering structure.

In an embodiment, the grouping of the N first substrates into M substrate clusters may be achieved by first grouping the N feature matrices into M feature clusters, each of the M feature clusters may comprise one or more feature matrices. Then, the M substrate clusters may be determined based on the M feature clusters, wherein each of the M substrate clusters may be associated with a respective one of the M feature clusters. The N feature matrices are grouped in such a manner that the one or more feature matrices of a given feature cluster are closer to a centroid of the given feature cluster than a centroid of any other feature cluster. Each of the N first substrates may be labelled as belonging to one of the M feature clusters when the first substrate falls within the corresponding feature cluster.

In an embodiment, the first substrate may be selected from among the N first substrates based on matching between a fingerprint associated with one of the M substrate clusters and a fingerprint associated with the second substrate. Alternatively, or in addition, the first substrate may be selected from among the N first substrates based on a difference between a fingerprint of one of the N first substrates and a fingerprint associated with the second substrate. Alternatively, or in addition, the first substrate may be selected from among the N first substrates based on an optimal post-bonding performance of the bonded substrate.

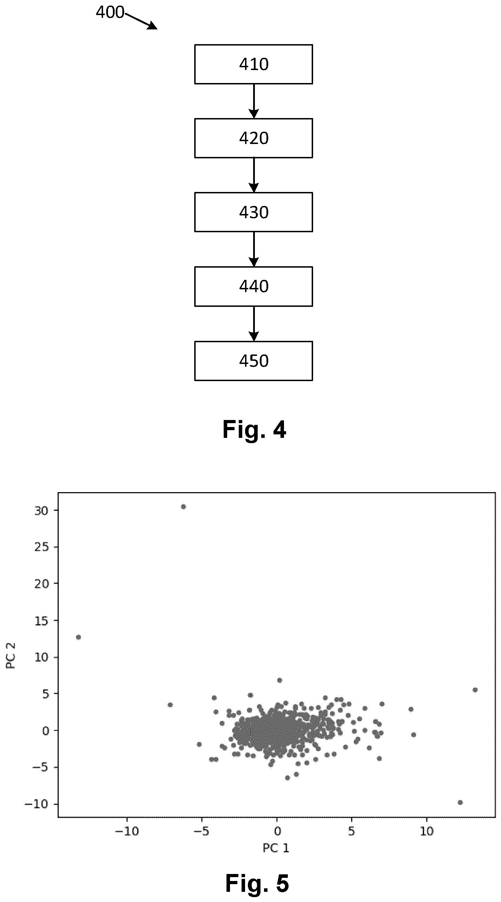

Figure 4 shows a flowchart of the proposed method of bonding substrates to form a bonded substrate, in accordance with an embodiment. As shown in Figure 4, the method 400 may comprise for example five main steps, i.e. steps 410-450.

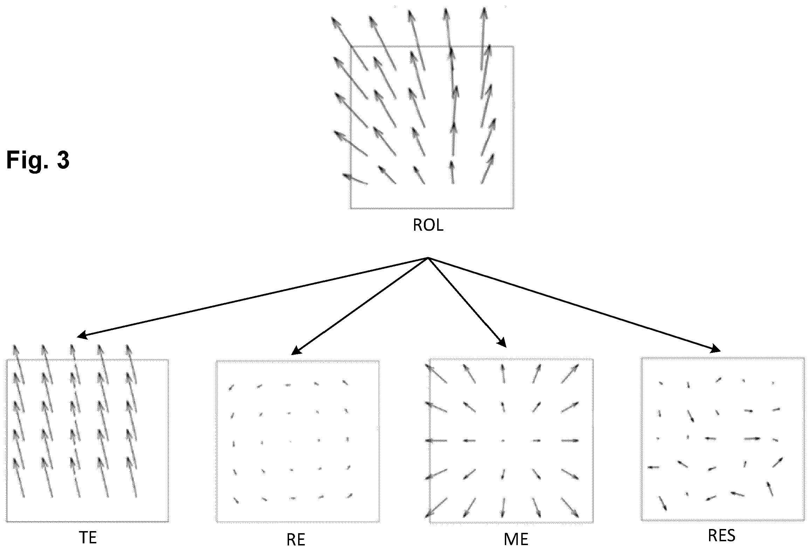

Step 410 may comprise obtaining N sets of first measurement data which may be obtained after having performed measurements on N first substrates, where N is an integer. Each of the N sets of first measurement data may be associated with a respective one of the N first substrates. Each set of first measurement data may be for example overlay or alignment data of the corresponding first substrate. In an example implementation and referring back to Figure 3, each set of first measurement data may be a measured overlay fingerprint ROL which may be corrected (e.g., by applying high-order overlay corrections) to remove the correctable components, e.g., the translation error TE, the rotation error RE, and the magnification error ME. The residual overlay fingerprint RES remaining after the corrections may be used for the subsequent steps.

Step 420 may comprise obtaining N feature matrices based on the N sets of first measurement data. Each of the N feature matrices may be associated with a respective one of the N sets of first measurement data and may be composed of one or more feature vectors, values of the feature vectors, and optionally other descriptive information (e.g., wafer coordinate origin of the associated die). Continued with the above example implementation, the columns of each feature matrix may be different feature vectors (one feature vector per column) while the rows of the matrix may be measured values of the respective feature vectors. In the case of the residual overlay fingerprint RES, a first feature vector may be defined as X-axis residual overlay and a second feature vector may be defined as Y-axis residual overlay. The first feature vector and the second feature vector may each be measured over the corresponding first substrate. As such, each feature matrix may comprise two columns respectively for X-axis residual overlay and Y-axis residual overlay and a plurality of rows, wherein each row may comprise an X-axis residual overlay value and a Y-axis residual overlay value both corresponding to a particular location on the corresponding first substrate.

In some cases, dimensionality reduction techniques (e.g., principal component analysis (PCA)) may be used to reduce the dimensions of the N feature matrices to obtain N processed feature matrices. Figure 5 shows an example plot of the N processed feature matrices obtained after having applied PCA to the N feature matrices. As shown in Figure 5, each data point in the plot may correspond to a respective one of the N processed feature matrices and may be composed of the first two principal components PC1, PC2 of the corresponding feature matrix. Reducing the dimensions of each of the N feature matrices may simplify the clustering process and therefore may enable a more efficient selection of the first substrate for bonding with the second substrate.

Step 430 may comprise grouping or clustering the N feature matrices into M feature clusters, each of the M feature clusters comprises one or more feature matrices, where M is an integer and where M<N. The M substrate clusters may then be determined based on the M feature clusters, wherein each of the M substrate cluster is associated with a respective one of the M feature clusters. For each of the M feature clusters, a representative feature matrix may be determined to represent all the feature matrices comprised within the corresponding feature cluster. The representative feature matrix may be for example the mean of all the feature matrices comprised within the corresponding feature cluster. Once determined, the M representative feature matrices may be used in the subsequent selection process instead of using the N feature matrices associated respectively with the N first substrates. Since M may be significantly smaller than N, the use of the representative feature matrices may significantly simplify the substrate selection process (see below for more details).

The grouping of the N feature matrices may be achieved using a clustering technique, such as for example K-means clustering. The clustering technique may be applied to the N feature matrices directly. Alternatively, the N feature matrices may be processed first (e.g., to reduce the dimension of each feature matrix) before being grouped into the M feature clusters.

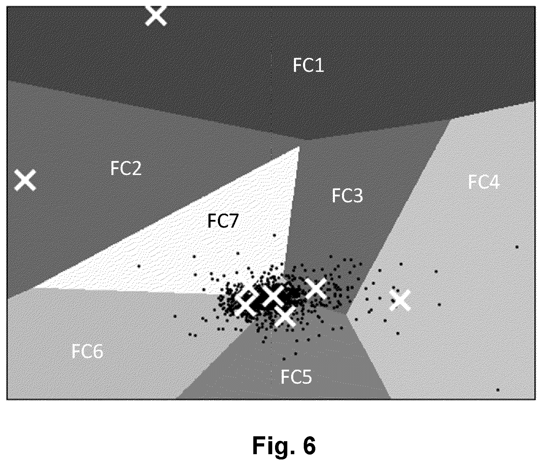

For example, K-means clustering may be applied to the N processed feature matrices shown in the plot of Figure 5 to group the plotted data points into M feature clusters, where M may be several orders of magnitude lower than N. Figure 6 shows an example implementation of using K-means clustering to group the N processed feature matrices (e.g., as shown in Figure 5) into M (e.g., 7) feature clusters FC1-FC7, wherein the centroid (or the cluster center) of each of the M feature clusters FC1-FC7 is indicated by a white cross. The centroid (or cluster center) may be either the mean or median of all the data points (each data point corresponding to a feature matrix either with the full dimensions or with reduced dimensions) within the cluster depending on the characteristics of the data. As such, each centroid may be regarded as a representative feature matrix associated with the corresponding feature cluster. The number of centroids may be chosen based on the required resolution balanced by the computational cost of finding an optimal match between one of the N first substrates (e.g., donor dies) and the second substrate (e.g., acceptor wafer). Once the clustering process is complete, every data point within a given feature cluster may be closer to the centroid of the given feature cluster than a centroid of any other feature cluster.

Step 440 may comprise labelling each of the N first substrates as belonging to one of the M feature clusters when the feature matrix associated with the first substrate falls within the corresponding feature cluster. The first substrates may be labelled in any manner that is known in the art. For example, each first substrate may be labelled with the centroid of the feature cluster to which the first substrate belongs. The label of each first substrate may be added to the feature matrix associated with that substrate.

Step 450 may comprise selecting one first substrate from among the N first substrates for bonding with the second substrate by solving an optimization problem.

The optimization problem may be defined to determine a feature cluster from among the M feature clusters based on their respective centroids (which may be mean feature matrices) and the one or more characteristic (e.g., a fingerprint) of the second substrate. The optimization problem may be in the form of a user defined utility function (see below). The mean feature matrices (e.g., meaning residual overlay fingerprints) of the feature clusters and the (e.g., overlay) fingerprint of the second substrate may be provided, as input, to the optimization problem.

The optimization problem may output an output value for each pair of one of the M mean feature matrices and the fingerprint of the second substrate. This may result in M output values. The output values may indicate one or more of: matching between a mean feature matrix associated with one of the M substrate clusters and a fingerprint associated with the second substrate, a difference between a mean feature matrix of one of the N first substrates and a fingerprint associated with the second substrate, and a post-bonding performance of the bonded substrate.

The optimization problem may determine a feature cluster based on the obtained output values. In some example implementations, the optimization problem may determine a feature cluster if its centroid results in an acceptable output value. The acceptable output value may indicate one or more of: an optimal match between a mean feature matrix associated with one of the M substrate clusters and a fingerprint associated with the second substrate, a minimal difference between a mean feature matrix of one of the N first substrates and a fingerprint associated with the second substrate, and an optimal post-bonding performance of the bonded substrate.

In an example implementation, the optimization problem may be defined in mathematically terms as: $Cos \left({θ}_{i , k}\right) = \frac{\left〈{w}_{i}, {d}_{k}\right〉}{\left‖{w}_{i}\right‖ \left‖{d}_{k}\right‖} ,$ where *dₖ* (k = 1, 2, ... M) denotes one of the M cluster centroids or cluster centers (e.g., mean residual overlay fingerprints), *wᵢ* denotes a (e.g., overlay) fingerprint of portion i of the second substrate, 〈 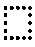 〉 is the inner product between two vectors, and ∥ 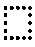 ∥ is the norm of a vector. In this example implementation, the N first substrates may be N individual dies, and the second substrate may be a wafer. According to equation [1], for an optimal pairing where the overlay fingerprints are directly opposite between the die and wafer, the angle *θ* is as close as possible to 180° ; whereas for an optimal pairing where the overlay fingerprints are directly aligned between the die and wafer, the angle *θ* is as close as possible to 0°. Therefore, based on the output values of the equation [1], a desired feature cluster may be determined. In this formulation, it may be also possible to perform a weighted inner product that allows for certain features to be given priority in the optimization.

Once the feature cluster is determined, any one of the first substrates comprised therewithin may be used as the selected first substrate for bonding with the second substrate. Therefore, grouping the N feature matrices (associated respectively with the N first substrates) into M clusters reduces the problem complexity from N factorial combinations to *N* * M calculations.

In an embodiment, the proposed method (e.g., method 400) may further comprise bonding the selected first substrate to the second substrate to form the bonded substrate. The bonded substrate may be for example a die-to-wafer bonded wafer or a wafer-to-wafer bonded wafer.

In an embodiment, the proposed method (e.g., method 400) may further comprise measuring the bonded substrate to determine a post-bonding performance of the bonded substrate. The post-bonding performance of the bonded substrate may be indicated by e.g., an overlay fingerprint of the bonded substrate, which may be less than 50 nm, less than 40 nm, less than 30 nm, or less than 20 nm.

In an embodiment, the proposed method (e.g., method 400) may further comprise adjusting the clustering structure of the N first substrates based on the measured post-bonding performance of the bonded substrate. For example, in the case where the measured overlay fingerprint of the bonded substrate is greater than a threshold overlay value (e.g., > 50 nm), it may suggest that the resolution of the clustering structure is not sufficiently high. Therefore, the number of the feature clusters may be increased (e.g., from M to M', where M' is an integer and M<M'<N) and the N feature matrices may be regrouped into M' feature clusters, one of which may then be selected e.g., through solving an optimization problem.

Another aspect of the present disclosure provides a computer program comprising program instructions operable to perform the proposed method, when run on a suitable apparatus (e.g., a computing resource). The computer program may be stored in a non-transient computer program carrier which may be comprised in a processing apparatus. The processing apparatus may be part of a lithographic apparatus or a substrate bonding apparatus.

Further embodiments of the invention are disclosed in the list of numbered clauses below:
1. A method of bonding substrates to form a bonded substrate, comprising: assigning M labels to N first substrates based on similarity between the N first substrates such that each of the N first substrates is assigned with one of the M labels, where M and N are both integers and where M<N; and selecting one first substrate from among the N first substrates for bonding with a second substrate based on the labels of the N first substrates and at least one characteristic of the second substrate.
2. A method according to clause 1, wherein the step of assigning M labels to N first substrates comprises determining a clustering structure of the N first substrates based on N sets of first measurement data, wherein each of the N sets of first measurement data is associated with a respective one of the N first substrates, and wherein the M labels are associated with M substrate clusters respectively.
3. A method according to clause 2, wherein the clustering structure is determined based on similarity between fingerprints of the respective N sets of first measurement data.
4. A method according to clause 2 or 3, wherein the step of assigning M labels to N first substrates further comprises labelling each of the N first substrates with one of the M labels based on the clustering structure.
5. A method according to any of clauses 2 to 4, wherein the first substrate is selected from among the N first substrates based on one or more of: matching between a fingerprint associated with one of the M substrate clusters and a fingerprint associated with the second substrate, a difference between a fingerprint of one of the N first substrates and a fingerprint associated with the second substrate, and an optimal post-bonding performance of the bonded substrate.
6. A method according to any of clauses 2 to 5, wherein the step of determining a clustering structure comprises: obtaining the N sets of first measurement data after having performed measurements on the N first substrates; obtaining N feature matrices based on the N sets of first measurement data, wherein each of the N feature matrices is composed of at least one feature vector and values thereof, and wherein each of the N feature matrices is associated with a respective one of the N sets of first measurement data; and grouping the N first substrates into the M substrate clusters based on the N feature matrices, thereby obtaining the clustering structure.
7. A method according to clause 6, wherein the step of grouping the N first substrates into M substrate clusters comprises: grouping the N feature matrices into M feature clusters, each of the M feature clusters comprises one or more feature matrices; and determining the M substrate clusters based on the M feature clusters, wherein each of the M substrate clusters is associated with a respective one of the M feature clusters.
8. A method according to clause 7, wherein the N feature matrices are grouped in such a manner that the one or more feature matrices of a given feature cluster are closer to a centroid of the given feature cluster than a centroid of any other feature cluster.
9. A method according to clause 7 or 8, wherein the step of labelling each of the N first substrates comprises labelling each of the N first substrates as belonging to one of the M feature clusters when the first substrate falls within the corresponding feature cluster.
10. A method according to any of clauses 7 to 9, wherein the grouping of the N feature matrices into the M feature clusters is achieved using a clustering technique.
11. A method according to clause 10, wherein the clustering technique is K-means clustering.
12. A method according to any of clauses 9 to 11, wherein the first substrate is selected from among the N first substrates by solving an optimization problem.
13. A method according to clause 12, wherein the step of selecting one first substrate from among the N first substrates comprises: providing an optimization problem defined to determine a feature cluster from among the M feature clusters based on their respective centroids and the at least one characteristic of the second substrate; obtaining an output value from the optimization problem for each pair of one of the M centroids and the at least one characteristic of the second substrate that have been provided as input to the optimization problem; determining a feature cluster based on the obtained output values; and using one of the one or more first substrates of the feature cluster as the selected first substrate.
14. A method according to clause 13, wherein the feature cluster is determined if its centroid results in an acceptable output value.
15. A method according to clause 14, wherein the acceptable output value indicates one or more of: an optimal match between one of the M centroids and the at least one characteristic of the second substrate, a minimal difference between one of the M centroids and the at least one characteristic of the second substrate, and an optimal post-bonding performance of the bonded substrate.
16. A method according to clause 14 or 15, wherein the optimization problem is reconfigurable based on a measured post-bonding performance of the bonded substrate.
17. A method according to any of clauses 2 to 16, wherein each of the N sets of first measurement data comprises overlay or alignment data of the corresponding first substrate.
18. A method according to any preceding clause, wherein the one or more characteristics of the second substrate comprise characteristics of overlay or alignment data of the second substrate.
19. A method according to any preceding clause, wherein the N first substrates are N individual dies, or N dies of a reconstituted wafer, or N individual wafers, or N individual reconstituted wafers.
20. A method according to any preceding clause, wherein the second substrate is a wafer or a reconstituted wafer.
21. A method according to any preceding clause, further comprising bonding the selected first substrate to the second substrate to form the bonded substrate.
22. A method according to clause 21, further comprising measuring the bonded substrate to determine a post-bonding performance of the bonded substrate.
23. A method according to clause 22, further comprising adjusting the clustering structure of the N first substrates based on the measured post-bonding performance of the bonded substrate.
24. A method according to clause 22 or 23, wherein the measured post-bonding performance comprises an overlay error of less than 50 nm.
25. A method according to clause 22 or 23 or 24, wherein the measured post-bonding performance comprises an overlay error of less than 20 nm.
26. A computer program comprising program instructions operable to perform the method of any of clauses 1 to 20, when run on a suitable apparatus.
27. A non-transient computer program carrier comprising the computer program of clause 26.
28. A processing apparatus comprising: at least one processor; and the non-transient computer program carrier of clause 27.
29. A lithographic apparatus being operable to perform the method of any of clauses 1 to 25.
30. A substrate bonding apparatus being operable to perform the method of any of clauses 1 to 25.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and substrate optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of bonding substrates to form a bonded substrate, comprising:
assigning M labels to N first substrates based on similarity between the N first substrates such that each of the N first substrates is assigned with one of the M labels, where M and N are both integers and where M<N; and
selecting one first substrate from among the N first substrates for bonding with a second substrate based on the labels of the N first substrates and at least one characteristic of the second substrate.

2. A method as claimed in claim 1, wherein the step of assigning M labels to N first substrates comprises determining a clustering structure of the N first substrates based on N sets of first measurement data, wherein each of the N sets of first measurement data is associated with a respective one of the N first substrates, and wherein the M labels are associated with M substrate clusters respectively.

3. A method as claimed in claim 2, wherein the clustering structure is determined based on similarity between fingerprints of the respective N sets of first measurement data.

4. A method as claimed in claim 2, wherein the step of assigning M labels to N first substrates further comprises labelling each of the N first substrates with one of the M labels based on the clustering structure.

5. A method as claimed in claim 2, wherein the first substrate is selected from among the N first substrates based on one or more of:
matching between a fingerprint associated with one of the M substrate clusters and a fingerprint associated with the second substrate,
a difference between a fingerprint of one of the N first substrates and a fingerprint associated with the second substrate, and
an optimal post-bonding performance of the bonded substrate.

6. A method as claimed in claim 2, wherein the step of determining a clustering structure comprises:
obtaining the N sets of first measurement data after having performed measurements on the N first substrates;
obtaining N feature matrices based on the N sets of first measurement data, wherein each of the N feature matrices is composed of at least one feature vector and values thereof, and wherein each of the N feature matrices is associated with a respective one of the N sets of first measurement data; and
grouping the N first substrates into the M substrate clusters based on the N feature matrices, thereby obtaining the clustering structure.

7. A method as claimed in claim 6, wherein the step of grouping the N first substrates into M substrate clusters comprises:
grouping the N feature matrices into M feature clusters, each of the M feature clusters comprises one or more feature matrices; and
determining the M substrate clusters based on the M feature clusters, wherein each of the M substrate clusters is associated with a respective one of the M feature clusters.

8. A method as claimed in claim 7, wherein the N feature matrices are grouped in such a manner that the one or more feature matrices of a given feature cluster are closer to a centroid of the given feature cluster than a centroid of any other feature cluster.

9. A method as claimed in claim 7, wherein the step of labelling each of the N first substrates comprises labelling each of the N first substrates as belonging to one of the M feature clusters when the first substrate falls within the corresponding feature cluster.

10. A method as claimed in claim 9, wherein the first substrate is selected from among the N first substrates by solving an optimization problem.

11. A method as claimed in claim 10, wherein the step of selecting one first substrate from among the N first substrates comprises:
providing an optimization problem defined to determine a feature cluster from among the M feature clusters based on their respective centroids and the at least one characteristic of the second substrate;
obtaining an output value from the optimization problem for each pair of one of the M centroids and the at least one characteristic of the second substrate that have been provided as input to the optimization problem;
determining a feature cluster based on the obtained output values; and
using one of the one or more first substrates of the feature cluster as the selected first substrate.

12. A method as claimed in claim 2, wherein each of the N sets of first measurement data comprises overlay or alignment data of the corresponding first substrate.

13. A method as claimed in claim 1, wherein the one or more characteristics of the second substrate comprise characteristics of overlay or alignment data of the second substrate.

14. A method as claimed in claim 1, wherein the N first substrates are N individual dies, or N dies of a reconstituted wafer, or N individual wafers, or N individual reconstituted wafers.

15. A computer program comprising program instructions operable to perform the method of claim 1, when run on a suitable apparatus.
